Europäisches Patentamt

European Patent Office

Office européen des brevets

(11) Publication number: **0 072 857**
**B1**

(12) **EUROPEAN PATENT SPECIFICATION**

(45) Date of publication of patent specification: **10.05.89**

(21) Application number: **82901067.7**

(22) Date of filing: **19.02.82**

(86) International application number:
**PCT/US82/00206**

(87) International publication number:
**WO 82/02966 02.09.82 Gazette 82/21**

(51) Int. Cl.⁴: **H 04 L 5/16,** G 01 R 21/00,
H 02 J 13/00

(54) DATA COMMUNICATION SYSTEM.

(30) Priority: **26.02.81 US 238205**

(43) Date of publication of application:
**02.03.83 Bulletin 83/09**

(45) Publication of the grant of the patent:
**10.05.89 Bulletin 89/19**

(84) Designated Contracting States:
**CH DE FR GB LI**

(56) References cited:
**CH-A- 574 690**
**FR-A- 950 746**
**US-A-3 310 626**
**US-A-3 541 523**
**US-A-3 754 211**
**US-A-4 061 975**
**US-A-4 270 205**

(73) Proprietor: **GENERAL ELECTRIC COMPANY**
**1 River Road**
**Schenectady New York 12305 (US)**

(72) Inventor: **KELLOGG, Richard Allan**
**306 Parsons Drive**
**Syracuse, NY 13219 (US)**
Inventor: **MAY, John Bruce**
**3935 Willowbrook Road**
**Liverpool, NY 13088 (US)**
Inventor: **JOHNSON, Brian Cory**
**116 Huntington Road**
**Syracuse, NY 13219 (US)**

(74) Representative: **Sanders, Peter Colin**
**Christopher et al**
**BROOKES & MARTIN High Holborn House 52/54**
**High Holborn**
**London WC1V 6SE (GB)**

Courier Press, Leamington Spa, England.

## Description

This invention relates to a data communication system for the exchange of serial digital signal information between a programmable power meter and a remote programming/readout unit.

It is known to provide a programmable multiple rate kilowatt hour meter for use in measuring electrical energy consumption at the premises of individual electric utility customers. Such a meter is typically completely enclosed within a weatherproof housing. The communication system of the present invention is intended to provide means for signal coupling to that meter by a separate electrical device to program the meter and to read out customer billing information. That function is carried out through the data communication system of the present invention by communication with a separate signal processing unit which can be placed in proximity and coupled with the meter. Optical coupling is preferred since this is quick and convenient without threatening the physical integrity of the meter housing.

The rules of operation by which communications are carried out between such electrical devices over such a communication channel are important in determining the design of the data communication system.

In FR-A-950746 there is described a duplex communication system in which pulse modulated signals are transmitted and received over a data channel at a controlled radio frequency. Master and slave processing units are connected at opposite ends of the channel, each being selectively operable to function either as a sending unit or as a receiving unit. There is, however, no provision for controlling the rate or time at which binary data is communicated, particularly when data transmission is on an irregular basis. The system is not therefore suitable for use between a programmable power meter and a remote programming/readout unit where data is transferred only in the intervals when the meter is not performing its normal metering function.

US-A-4061975 discloses self-clocking pulse width modulators and demodulators for transmitting digital data over a single communication line.

US-A-3,310,626 discloses an automatic telegraph transmission system in which the telegraph signals are of the type in which each character consists of a "start" unit, a plurality of data units, and a "stop" unit. The system incorporates series-to-parallel shift registers in which detection of a "start" unit in the "start" stage of the register indicates that the register is full.

The present invention provides an improved data communication system operating in accordance with very simple rules, or modes of operation, and providing a significant improvement over prior data communication systems between programmable power meters and remote programming/readout units.

According to the present invention there is provided a data communication system for exchanging digital signal information between a programmable power meter and a remote programming/readout unit, the system comprising master and slave processing units adapted to be communicatively coupled to opposite ends of a data channel, each of the processing units being selectively operable to function either as a sending unit or as a receiving unit, characterised in that the master processing unit includes a master control unit responsive to control signals (EMC) generated by the power meter to emit clock pulse signals, and responsive to a message received from the slave processing unit for determining the said operating function of the processing units, each of the units including a send register for storing the data to be transmitted and a receive register for receiving the transmitted data, the master unit further including gating means responsive to the clock pulse signals and to the output of the master send register such that, with the master unit operating as a sending unit, a meter reading stored as binary bits in the send register is serially transferred over the data channel to the receive register in the slave unit, and such that, with the master unit operating as a receiving unit, the clock pulse signals are transferred over the data channel to the slave unit, the slave unit further including means responsive to the clock pulse signals received from the master unit and to the output of the slave send register such that, with the slave unit operating as a sending unit, data bits representing a message signal stored in the slave send register are serially transferred over the data channel to the receive register in the master unit, the serial data transfer being such that the data bits are transmitted as long and short pulses, each data bit being transmitted at a pulse of the clock pulse signals emitted by the master control unit such that each clock pulse forms at least part of each data bit transferred in either direction over the data channel.

In the accompanying drawings, by way of example only:

FIG. 1 is a schematic circuit diagram of a master processing unit which is one unit of a preferred embodiment of the data communication system of this invention for transmitting and receiving data through a data channel to and from another processing unit.

FIG. 2 is a schematic circuit diagram of a slave processing unit forming a part of the preferred embodiment of the data communication system in accordance with the present invention for transmitting and receiving data through a data channel to and from the master processing unit of FIG. 1.

FIG. 3 is a timing diagram showing idealized wave forms of the pulse signals, and the timing relationships between pulse signals generated and received by the master and slave processing units of FIGS. 1 and 2 during the sending and receiving of information over the interconnecting data channel.

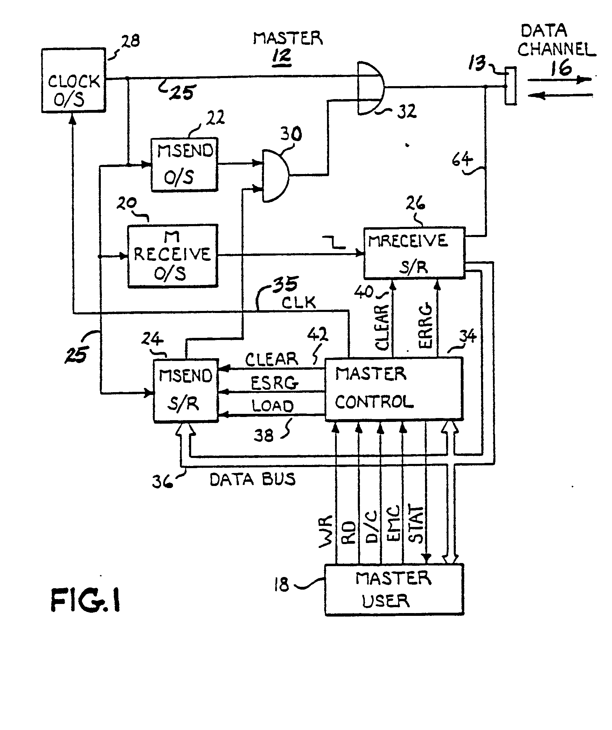

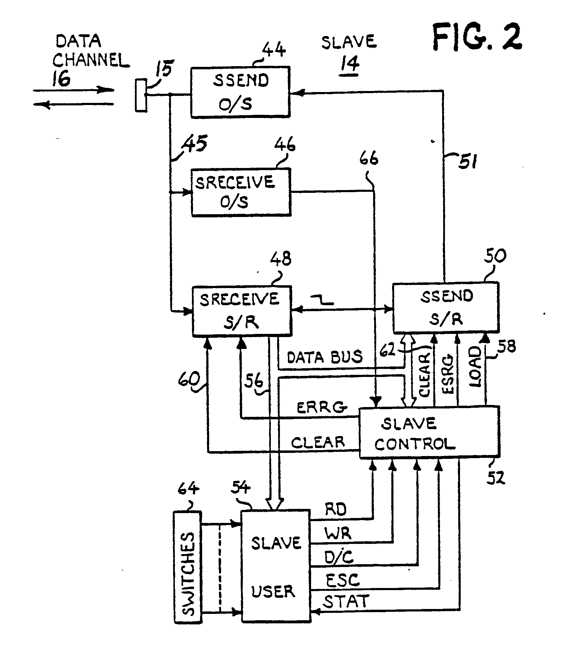

Reference is now made to FIGS. 1 and 2 where there is shown, collectively, a data communication system comprised of a master processing unit 12 (FIG. 1) and a slave processing unit 14 (FIG. 2) communicatively coupled via a data channel 16. Data channel 16 is shown in both FIG. 1 and FIG. 2.

The communication link data channel 16 coupling between the master 12 and the slave 14 can be established by various known means. For example, the data channel 16 can be coupled optically or magnetically, or by direct electrical connection. In the preferred embodiment of the present invention, the data is to be transmitted and received between a master 12 and a slave 14 wherein the master processing unit serves a master user unit 18 which comprises a programable multiple rate kilowatt hour meter and the slave processing unit comprises a unit for transmitting commands to that kilowatt hour meter and receiving readings from that kilowatt hour meter. In such a system, it is important to be able to very conveniently bring the portable slave processing unit into a physically coupled relationship with the master processing unit 12 through the data channel 16. For this purpose, an optical coupling is preferred. Since data is to be transmitted and received through the data channel by each of the processing units 12 and 14, such an optical coupling will preferably include a light source optical transmitter from each unit to a light responsive optical receiver at each unit. However, in order to simplify the presentation of the present invention, the optical transmitter and receiver in each unit is represented by a single element. That element is represented at 13 for the master processing unit 12, and at 15 for the slave processing unit 14.

Regardless of the type of coupling used, all information exchanged between the master 12 and slave 14 is in serial digital signal form. That is, all information transferred over the data channel 16 is in the form of pulses having binary states (i.e. "1" or "0"). It is a unique feature of the present invention that a logic 0 is transmitted as a short pulse, and a logic 1 is transmitted as a long pulse. The serial binary digital signals are combined in groups to convey messages, commands, or information items to be operated upon or processed. Such digital signal groups are generally referred to below as messages.

The master 12 serves a master unit 18 (hereinafter referred to as master user 18). The master processing unit includes a master receive one-shot pulse generator 20, a master send one-shot pulse generator 22, a master send shift register 24, a master receive shift register 26, a clock one-shot pulse generator 28, an AND-gate 30, an OR-gate 32, and a master control 34. The master control 34 can be implemented with conventional discrete logic elements, or preferably by a microprocessor such as an RCA 1802. A bi-directional data bus 36 interconnects master user 18, master control 34, receive register 26, and send register 36.

The master user 18 includes an independent microprocessor. The master user 18 may also be implemented with an RCA 1802 microprocessor. In the preferred embodiment, the master user 18 also comprises a programmable multiple rate kilowatt-hour meter as previously mentioned above.

The microprocessor of the programmable meter (master user 18) typically operates almost continuously to perform many important functions other than communication with slave 14, such as measurement of power consumption, calculation of peak and demand power consumption at prescribed intervals, and switching loads on and off.

The performance and completion of these functions takes precedence over all external communications with the meter. That is, the meter (master user 18) is programmed to give precedence to the performance of its internal functions, and will communicate externally with the programmer/reader (slave 14) only when it has time to do so. The master user 18 operates completely independently and asynchronously of the communication master processing unit 12. The master user 18 will signal the master control 34 when the master user 18 is available to participate in an information transfer between the master user 12 and the slave 14.

The slave processing unit 14 of FIG. 2 is quite similar in structure to master 12. The main structural difference between the slave 14 and the master 12 is that the former does not contain a clock one-shot pulse generator 28 or gates 30 and 32.

The slave 14 is comprised of a slave send one-shot pulse generator 44, a slave receive one-shot pulse generator 46, a slave receive shift register 48, a slave send shift register 50, a slave control 52, and a slave user unit 54. A bi-directional data bus 56 is also provided to interconnect the control 52, user 54 and registers 48 and 50 in a manner similar to bus 36 in the master 12. Signal lines running between the slave user 54 and the slave control 52 carry similar nomenclature as that illustrated in FIG. 1 between master user 18 and master control 34. Further, a load line 58, clear lines 60 and 62, an enable send register (ESRG) line and an enable receive register (EERG) line are provided for controlling the send and receive registers 50 and 48. Similar lines having similar labels are provided in the master 12.

The slave user 54 of FIG. 2 is preferably implemented by a microprocessor, such as an INTEL 8085, and contains its own program for communicating with the slave control 52. The slave control 52 may be substantially identical to the master control 34. To cause the slave user 54 to carry out various operations, such as read or write to the data bus 56, or to cause the slave 14 to send or receive digital signal information, a plurality of action control switches 64 are provided. As previously mentioned, the slave 14 in the preferred embodiment, is a microprocessor based meter programmer/reader apparatus. For that purpose, the selective activation of the various switches 64 will provide input control signals to the slave user 54, directing the performance of selected functions.

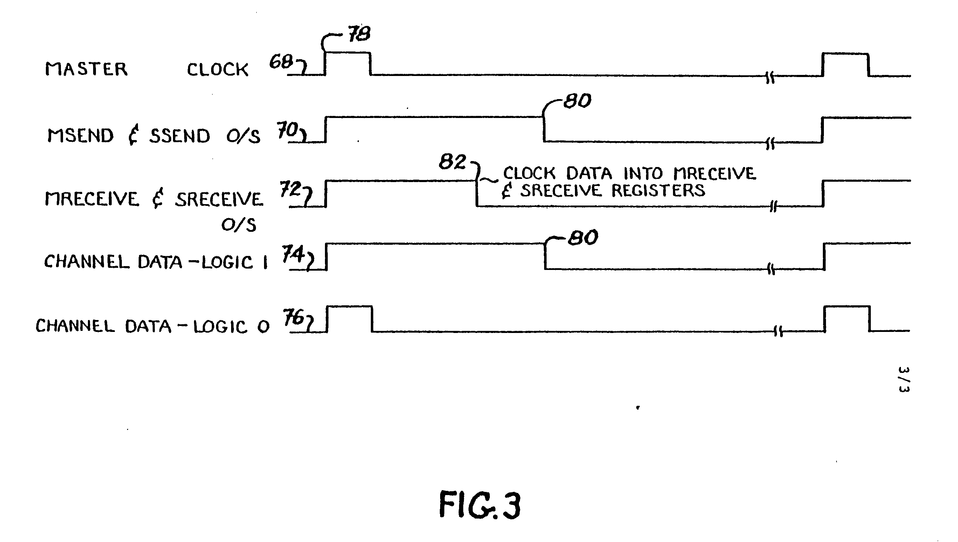

FIG. 3 is an idealized pulse wave form diagram indicating the relative initiation times and durations of the various pulses emitted by different components of the master unit 12 and the slave unit 14. The first curve 68 illustrates the pulses emitted by the clock 28 each time a binary bit of information is to be transmitted by either unit and received by the other. The curve 70 represents the timing and duration of the pulses emitted by either the MSEND or SSEND one-shot pulse generator whenever the associated unit (12, 14) is transmitting. Similarly, curve 72 represents the relative timing and duration of the pulses emitted by either the MRECEIVE or the SRECEIVE one-shot pulse generator whenever the associated unit (12, 14) is receiving. Curve 74 illustrates the relative duration of each of the pulses transmitted through the data channel signifying a logic 1. Curve 76 illustrates the timing and the duration of each of the pulses transmitted through the data channel signifying a logic 0.

The following is a brief description of the transmission of data from master 12 (FIG. 1) to slave 14 (FIG. 2) with reference to the curves of FIG. 3. Whenever a bit (a binary digit) of information is to be transmitted, the master control 34 issues a clock pulse on a control line 35 to the clock one-shot pulse generator 28. In response to that signal, the clock pulse generator 28 generates a short clock pulse on output connection 25. The leading edge of that pulse is indicated at 78 in the curve 68 of FIG. 3. Prior to the commencement of the issuance of clock pulses by the clock 28, the entire message to be sent is stored in the MSEND shift register 24. The clock pulse is supplied through the connection 25 to the OR gate 32 and to the MSEND one-shot pulse generator 22 and to the MSEND shift register 24. The OR gate 32 is effective in response to the signal received directly from master clock 28 on connection 25 to provide at least a short pulse output corresponding to the duration of the clock pulse to the optical coupling output element 13 for transmission through the data channel 16 to the slave unit 14. If there is no prolongation of that pulse by the other input to OR gate 32, the short pulse is received and recognized by slave 14 as a logic 0 binary bit, as shown at curve 76 of FIG. 3.

If the binary bit to be currently sent from the MSEND shift register 24 is a logic 0 bit, then the master clock pulse supplied on connection 25 to the MSEND shift register 24 does not result in any output from the MSEND shift register 24 to the AND gate 30. Accordingly, AND gate 30 is not enabled, and the short pulse output from OR gate 32 is not extended. However, if the binary bit to be transmitted is a logic 1, the MSEND shift register 24 output enables the AND gate 30. Furthermore, the output from clock 28 supplied on connection 25 to the MSEND one-shot pulse generator 22 causes that generator to issue a longer pulse, as indicated in curve 70 of FIG. 3. The result is that AND gate 30 is activated to provide an output to OR gate 32 to prolong the output from the master 12 through data channel 16 to the slave 14 for an interval determined by the duration of the MSEND pulse output as shown in curve 70 of FIG. 3. This is recognized by the slave 14 as a logic 1 signal, as illustrated in curve 74 of FIG. 3. Thus, the MSEND pulse and the resultant logic 1 pulse continue to point 80, as indicated in curves 70 and 74.

Referring now to FIG. 2, the initiation of the clock pulse (at 78 in FIG. 3) is detected through data channel 16 and the optical signal element 15, acting as a receiver, and thus through the connection 45 by the SRECEIVE one-shot pulse generator 46 and by the SRECEIVE shift register 48. In response to a short pulse logic 0 signal (curve 76 in FIG. 3), the SRECEIVE register 48 is caused to shift and record a logic 0. This occurs in the absence of a prolongation of the pulse to indicate a logic 1. However, the SRECEIVE one-shot pulse generator 46 is operable in response to the receipt of the input signal originating from the clock 28 to emit an intermediate length pulse on output connection 66, as shown in curve 72 of FIG. 3. That pulse terminates at point 82, substantially after the termination of the clock pulse (curve 68), but substantially earlier than the termination of the MSEND pulse 70 at that point 80. The signal on connection 66 from the SRECEIVE pulse generator 46 is supplied to the SRECEIVE shift register 48, and the downward excursion of that signal pulse at time point 82 in curve 72 tests for the presence of a prolonged logic 1 pulse (curve 74) at the SRECEIVE register 48. If that prolonged pulse is present, the SRECEIVE shift register operates to record that a logic 1 bit has been received. Thus, the clock pulse generator 28 not only initiates the operation of the transmission of an information bit, but also enables the receiving slave unit 14 to receive and record each information bit of the message.

When the data transmission is from the slave 14 to the master 12, the operation is substantially identical except that the master clock pulses from the clock one-shot circuit 28 are not locally generated in the slave 14, but must be received through the data channel 16 in order to initiate transmission from the slave 14. When the slave is in the transmiting mode and the master 12 is in the receiving mode, the MRECEIVE one-shot pulse generator circuit 20 (FIG. 1) is enabled through connection 25, the MRECEIVE shift register 26 is enabled through connection 64 from the output of OR gate 32, and SSEND one-shot pulse generator circuit 44 (FIG. 2) is enabled by the clock pulse signal transmitted through the data channel 16. The SSEND shift register 50 is enabled through the connection 45 and through the SRECEIVE one-shot circuit 46 and connection 66. The SSEND shift register 50 is operable, when it is transmitting a logic 1 bit, to provide a signal on connection 51 to the SSEND one-shot pulse generator 44 to enable that pulse generator to issue a prolonged pulse in accordance with curve 70 of FIG. 3. The presence of that prolonged pulse is detected through the data channel and connection 64 by the MRECEIVE shift register 26 at the end of the MRECEIVE pulse circuit 20 output (at point 82 of curve 72). Otherwise, the MRECEIVE shift register 26 will have received only a short pulse, recognized as a logic 0.

The master unit 12 and the slave unit 14 are each selectively operable to function either as a sending unit or as a receiving unit.

Each of the receive registers 26, 48 has a predetermined bit capacity for the storage of binary information bits, that capacity corresponding to a desired message length. Each associated control unit (the master control 34 for MRECEIVE register 26, and the slave control 52 for the SRECEIVE 48) is operable to periodically test the associated receive register to determine when the receive register is full, so as to indicate the receipt of a complete message. Each control unit 34, 52, is then operable to send the message back to the sending unit acknowledging that the complete message has been received.

In the preferred form of the invention, each of the receive registers 26, 48, is a shift register which is operable to receive the most significant bit of the message first, followed by bits of lesser significance. Preferably, each message includes a mandatory binary one as the first bit of the message. With this arrangement of the message, it is only necessary for the associated control unit 34, 52 to check for a binary one in the most significant bit position of the associated receive register 26, 48 to determine when the receive register is full.

In the preferred form of the invention, the acknowledgment signal sent by the control unit 34, 52 of the receiving processing unit 12 or 14 to indicate the receipt of a complete message is transmitted in response to a final clock pulse from the clock source 28.

The master control 34 of the master 12 and the slave control 52 of the slave 14 are preferably operable whenever the associated unit is in the receive mode to make a parity check on the message received by the associated receive register 26 or 48, and the control unit 34 or 52 is then preferably operable to generate the aforementioned acknowledgment signal in either one of two binary states which represent either a valid or an invalid parity check. Thus, for instance, if the acknowledgment signal is sent as a binary one, it indicates a valid parity check, and if it is sent as binary 0, it indicates an invalid parity check.

Preferably, the sending unit 12 or 14, when it receives the acknowledgment signal, operates to verify receipt of that acknowledgment and stores that information, including the information that the parity check was valid or invalid.

Additionally, in the preferred form of the invention, the control processor circuit 34 or 52 of the sending unit 12 or 14 is operable to repeatedly check the associated send register 24 or 50 for a condition of all binary 0's stored in that send register as an indication that all of the data has been shifted out of that associated send register and transmitted to the receiving unit. However, in order for this test to be reliable, it is preferred that a mandatory binary one be provided in the least significant digit position of each message. Thus, when the last digit is shifted out of each send register, a condition of all binary 0's reliably represents an empty condition of the register.

The following is a more detailed description of the structure and operation of the invention, with reference first to FIG. 1. An enable master control (EMC) signal line is provided from the master user 18 to the control 34. The EMC signal on that line is generated by the master user 18 when power is first applied, or at program interrupt times during the operation of the master user 18, to signal the master control 34 that the user 18 is available to perform an information transfer function.

The information transfer functions are generally in one of two classes: (1) requesting a previously received message stored in the MRECEIVE register 26; or (2) sending a message from the master user 18 to the slave 14 via the data channel 16. The class is determined by the state of the signals on three lines, RD (read), WR (write) and D/C (data or control) provided to the master control 34 from the master user 18. If the function is of the first class, RD is enabled (logic 1) and the D/C signal is disabled (logic 0), and WR is disabled (logic 0). In response to this combination, the master control 34 provides an enable receive register (ERRG) signal to the MRECEIVE register 26. The ERRG signal enables the register 26 to bi-directional data bus 36, and the contents of the register 26 are read by and stored in the master user 18.

If the function is of the second class (WR enabled, RD disabled), as specified by the master user 18, then the state of the data/control (D/C) signal from the user 18 specifies to the control 34 which one of the following sub-functions is to be performed:

1. If the D/C signal is enabled (logic 1), then the master control 34 generates a load signal on line 38, enabling the MSEND register 24 and loading a message from the master user 18 into the register 24 via the data bus 36. The MRECEIVE register 26 is also reset via a clear signal on line 40 from the master control 34.

2. If the D/C signal is not enabled (logic 0), then a control word is loaded into a control register (not separately shown) in the master control 34 from the master user 18 via the data bus 36. This control word is decoded in the master control 34 to specify whether the subfunction is to enable the master 12 to read digital signal information from the slave 14 or to send such information to the slave.

If data is to be sent to the slave 14, the MSEND register will have been previously loaded from the master user 18 as described in the preceding paragraph 1. If the master control 34 decode specifies that digital signal information is to be received from the slave 14, the master control 34 resets the MRECEIVE and MSEND registers 26 and 24 via the clear lines 40 and 42 respectively.

Once the master user 18 disables the signal on the EMC signal line, the master control 34 will operate independently of the master user 18 to either send data to or receive data from the slave 14.

The master user 18 can also interrogate the control register of the master control 34 via the data bus 36 and obtain status information by a signal on a stat signal line from the control 34 to the user 18. When the user 18 interrogates the master control 34, it enables the RD signal and disables the D/C signal. This combination of signals enables the master control to enable its control register to the data bus 36 and also provide the status information to the master user 18.

In FIG. 2, there are interconnections between the slave user 54 and slave control 52, and between the SSEND and SRECEIVE registers 50 and 48 and the slave control 52 which correspond exactly to the interconnections just described for the corresponding components of the master unit 12. The interconnections are similarly labeled, and the functions are substantially identical.

The slave user 54, under the control of manually operated switches 64, emits combinations of signals and commands to the slave control 52 corresponding to the signals and commands discussed above which were supplied from the master user 18 in FIG. 1 to the master control 34 in FIG. 1 to control the operation of the slave unit 14.

It is a significant operational characteristic of the invention that: (1) at initial system startup, or (2) at end of any data exchange between the master and slave, or (3) upon the detection of any error in the data being exchanged, the master 12 becomes the "listener" and the slave 14 becomes the "talker". Stated another way, upon the occurrence of either (1), (2), or (3), the master 12 will revert to a receive mode pending the receipt of a command or message from the slave 14.

However, in all data communications, the master 12 controls the data bit rate of transmission, and controls when an information exchange is to take place between the master and the slave by control of the emission of clock pulses from 28. Thus, no information exchange takes place unless the master control 34 of the master unit 12 initiates the emission of a clock pulse from pulse generator 28 by a clock signal on connection 35. Furthermore, the master control determines whether master 12 is to receive or send a message. However, the master 12 responds to requests from the slave 14 to send messages. When the slave transmits a message to the master 12 requesting information, the slave 14 then switches into the receive mode and waits to receive that information back from the master 12.

The operation of this system may be interrupted in the middle of a message by an interruption of the clock signals emitted from the master control 34 on connection 35 to control the operation of the master clock pulse generator 28. However, that message can be continued at any time, for interchange of one bit at a time, whenever a clock signal is available.

**Claims**

1. A data communication system for exchanging digital signal information between a programmable power meter (18) and a remote programming/readout unit (54, 64), the system comprising master (12) and slave (14) processing units adapted to be communicatively coupled to opposite ends of a data channel (16), each of the processing units being selectively operable to function either as a sending unit or as a receiving unit, characterised in that the master processing unit (12) includes a master control unit (34) responsive to control signals (EMC) generated by the power meter (18) to emit clock pulse signals (35, 28), and responsive to a message received from the slave processing unit (14) for determining the said operating function of the processing units (12, 14), each of the units (12, 14) including a send register (24, 50) for storing the data to be transmitted and a receive register (26, 48) for receiving the transmitted data, the master unit (12) further including gating means (30, 32) responsive to the clock pulse signals (28) and to the output of the master send register (24) such that, with the master unit (12) operating as a sending unit, a meter reading stored as binary bits in the send register (24) is serially transferred over the data channel (16) to the receive register (48) in the slave unit, and such that, with the master unit (12) operating as a receiving unit, the clock pulse signals (28) are transferred over the data channel to the slave unit (14), the slave unit (14) further including means (44, 46) responsive to the clock pulse signals (28) received from the master unit (12) and to the output of the slave send register (50) such that, with the slave unit operating as a sending unit, data bits representing a message signal stored in the slave send register (50) are serially transferred over the data channel (16) to the receive register (26) in the master unit (12), the serial data transfer being such that the data bits are transmitted as long and short pulses, each data bit being transmitted at a pulse of the clock pulse signals (28) emitted by the master control unit (34) such that each clock pulse forms at least part of each data bit transferred in either direction over the data channel (16).

2. A system as claimed in claim 1 further characterised by each of said receive registers (26, 48) having a predetermined capacity for the storage of binary data bits corresponding to a desired message length, and means (in 34, 52) to determine when each receive register (26, 48) is full to indicate the receipt of a complete message, and means (in 34, 52) operable in response to said means for determining that said receive register is full for sending a message back to the sending unit acknowledging that the complete message has been received.

3. A system as claimed in claim 2 further characterised in that each of said receive registers (26, 48) comprises a shift register operable to receive the most significant bit of the message first followed by bits of lesser significance, said means (in 34, 52) for determining whether said receive register is full comprising means to check for a binary one in the most significant bit position of said receive register so as to successfully indicate that said receive register is full when the first bit of each message is a mandatory binary one.

4. A system as claimed in claim 2 further characterised in that said means (in 34, 52) for sending said acknowledgement message is operable to send said signal in response to a final clock pulse from said clock source (28).

5. A system as claimed in claim 4 further characterised in that each of said processing units (12, 14) includes means (in 34, 52) for making a parity check on the message received by the associated receive register (26, 48), and said parity check means being operable in conjunction with said acknowledgement signal generating means for transmitting said acknowledgement signal in either one of two binary states respectively representing either a valid or an invalid parity check.

6. A system as claimed in claim 5 further characterised in that each of said processing units (12, 14) includes means (in 34, 52) operable when said unit is operating in the sending mode to verify the receipt of the acknowledgement signal from said receiving unit and to store the valid or invalid parity check information.

7. A system as claimed in claim 1, 2, 3, 4, 5 or 6, further characterised by each of said processing units (12, 14) including means (in 34, 52) connected to the associated send register (24, 50) to repeatedly check for a condition of all binary zeroes stored in said associated send register as an indication that all of the data has been shifted out of said associated send register and transmitted to the receiving unit so that said checking means is operable to accurately indicate when said associated send register is empty when a mandatory binary one is provided in the least significant digit position of each message to be sent.

8. A system as claimed in claim 1 further characterised in that each of said processing units (12, 14) includes a one-shot send pulse generator (22, 44) operable in conjunction with said associated send register (24, 50) in response to said clock pulse signals for transmitting over said data channel (16) a prolonged pulse (80) signifying the transmission of a logic one bit signal for each logic one binary bit stored in said associated send register.

9. A system as claimed in claim 8 further characterised in that each of said processing units (12, 14) includes a one-shot receive pulse generator (20, 46) which is connected to the associated receive register (26, 48) and which is connected to receive and operate in response to said clock pulse signals to issue to the associated receive register (26, 48) a prolonged pulse (82) which terminates prior to the termination of the logic one pulses (80) received from the sending unit, said receive register (26, 48) of the processing unit (12, 14) operating as a receiving unit being operable in response to the termination of the prolonged pulse from the associated one-shot receive pulse generator (20, 46) to recognise and store a logic one binary bit signal pulse.

## Patentansprüche

1. Datenkommunikationssystem zum Austausch digitaler Signalinformation zwischen einem programmierbaren Leistungsmesser (18) und einer entfernt angeordneten Programmier/Ausleseeinheit (54, 64), wobei das System Masterund Slave-Verarbeitungseinheiten (12, 14) aufweist, die kommunikativ mit den entgegengesetzten Enden eines Datenkanals (16) verbunden werden können, wobei jede der Verarbeitungseinheiten selektiv entweder als eine Sendeeinheit oder als eine Empfangseinheit arbeiten kann, dadurch gekennzeichnet, daß die Master-Verarbeitungseinheit (12) eine Master-Steuereinheit (34) aufweist, die auf durch den Leistungsmesser (18) erzeugte Steuersignale (EMC) anspricht, um Taktpulssignale (35, 28) abzugeben, und auf eine von der Slave-Verarbeitungseinheit (14) empfangene Nachricht anspricht zum Ermitteln der Betriebsfunktion der Verarbeitungseinheiten (12, 14), wobei jede der Einheiten (12, 14) ein Senderegister (24, 50) zum Speichern der zu übertragenden Daten und ein Empfangsregister (26, 48) aufweist zum Empfangen der übertragenen Daten, wobei die Master-Einheit (12) ferner Steuermittel (30, 32) aufweist, die auf die Taktpulssignale (28) und auf das Ausgangssignal des Master-Senderegisters (24) derart anspricht, daß, wenn die Master-Einheit (12) als eine Sendeeinheit arbeitet, eine Meßgeräte-Auslesung, die in binären Bits in dem Senderegister (24) gespeichert ist, seriell über den Datenkanal (16) zu dem Empfangsregister (48) in der Slave-Einheit übertragen wird, und daß, wenn die Master-Einheit (12) als eine Empfangseinheit arbeitet, die Taktpulssignale (28) über den Datenkanal zu der Slave-Einheit (14) übertragen werden, wobei die Slave-Einheit (14) ferner Mittel (44, 46) aufweist, die auf die von der Master-Einheit (12) empfangenen Taktpulssignale (28) und auf das Ausgangssignal des Slave-Senderegisters (50) derart ansprechen, daß, wenn die Slave-Einheit als eine Sendeeinheit arbeitet, die Datenbits, die ein in dem Slave-Senderegister (50) gespeichertes Nachrichtensignal darstellen, seriell über den Datenkanal (16) zu dem Empfangsregister (26) in der Master-Einheit (12) übertragen werden, wobei die serielle Datenübertragung in der Weise erfolgt, daß die Datenbits als lange und kurze Impulse übertragen werden, wobei jedes Datenbit, das bei einem Impuls der Taktpulssignale (28) übertragen wird, durch die Master-Steuereinheit (34) in der Weise abgegeben wird, daß jeder Taktimpuls wenigstens einen Teil von jedem Datenbit bildet, das in einer der beiden Richtungen über den Datenkanal (16) übertragen wird.

2. System nach Anspruch 1, dadurch gekennzeichnet, daß jedes Empfangsregister (26, 48) ein vorbestimmtes Fassungsvermögen zum Speichern von binären Datenbits entsprechend einer gewünschten Nachrichtenlänge aufweist, und Mittel (in 34, 52), um zu ermitteln, ob jedes Empfangsregister (26, 48) voll ist, um den Empfang einer vollständigen Nachricht anzugeben, und Mittel (in 34, 52) vorgesehen sind, die in Abhängigkeit von den Mitteln, die ermitteln, daß das Empfangsregister voll ist, in Betrieb setzbar sind, um eine Nachricht zurück an die Sendeeinheit zu senden, die bestätigt, daß die vollständige Nachricht empfangen worden ist.

3. System nach Anspruch 2, dadurch gekennzeichnet, daß jedes der Empfangsregister (26, 48) ein Schieberegister aufweist, das zunächst das höchstwertigste Bit der Nachricht empfängt, dem Bits von geringerer Wertigkeit folgen, wobei die Mittel (in 34, 52) zum Ermitteln, ob das Empfangsregister voll ist, Mittel aufweisen, die die höchstwertigste Bitposition des Empfangsregisters nach einer binären eins untersuchen, um so erfolgreich anzuzeigen, daß das Empfangsregister voll ist, wenn das erste Bit jeder Nachricht eine zwingende binäre eins ist.

4. System nach Anspruch 2, dadurch gekennzeichnet, daß die Mittel (in 34, 52) zum Senden der Bestätigungsnachricht das Signal bei einem letzten Taktimpuls aus dem Taktgeber (28) senden.

5. System nach Anspruch 4, dadurch gekennzeichnet, daß jede der Verarbeitungseinheiten (12, 14) Mittel (in 34, 52) aufweist zum Durchführen einer Paritätsprüfung in der Nachricht, die von dem zugeordneten Empfangsregister (26, 48) empfangen ist, wobei die Paritätsprüfungsmittel in Verbindung mit den das Bestätigungssignal erzeugenden Mittel betätigbar sind zum Übertragen des Bestätigungssignals in einem der zwei binären Zustände, die auf entsprechende Weise entweder eine gültige oder eine ungültige Paritätsprüfung darstellen.

6. System nach Anspruch 5, dadurch gekennzeichnet, daß jede der Verarbeitungseinheiten (12, 14) Mittel (in 34, 52) aufweist, die betätigbar sind, wenn die Einheit in dem Sendemodus arbeitet, um den Empfang des Bestätigungssignals von der Empfangseinheit zu überprüfen und die gültige oder ungültige Paritätsprüfungs-Information zu speichern.

7. System nach einem der Ansprüche 1 bis 6, dadurch gekennzeichnet, daß jede der Verarbeitungseinheiten (12, 14) Mittel (in 34, 52) aufweist, die mit dem zugeordneten Senderegister (24,50) verbunden sind, um wiederholt einen Zustand zu überprüfen, daß alle binären Nullen in dem zugeordneten Senderegister gespeichert sind, als eine Anzeige, daß alle Daten aus dem zugeordneten Senderegister herausgeschoben und zu der Empfangseinheit übertragen sind, so daß die Prüfeinrichtung betätigbar ist, um genau anzuzeigen, wenn das zugeordnete Senderegister leer ist, wenn eine zwingende binäre eins in der niedrigwertigsten digitalen Position jeder zu sendenden Nachricht geliefert ist.

8. System nach Anspruch 1, dadurch gekennzeichnet, daß jede der Verarbeitungseinheiten (12, 14) einen monostabilen Sendeimpulsgenerator (22, 44) aufweist, der in Verbindung mit dem zugeordneten Senderegister (24, 50) bei den Taktimpulssignalen betätigbar ist zum Übertragen eines verlängerten Impulses (80) über den Datenkanal (16), welcher Impuls die Übertragung eines eine logische eins darstellenden Bitsignals für jedes binäre Bit einer logischen eins anzeigt, das in dem zugeordneten Senderegister gespeichert ist.

9. System nach Anspruch 8, dadurch gekennzeichnet, daß jede der Verarbeitungseinheiten (12, 14) einen monostabilen Empfangsimpulsgenerator (20, 46) aufweist, der mit dem zugeordneten Empfangsregister (26, 48) verbunden und so geschaltet ist, daß er die Taktimpulssignale empfängt und in Abhängigkeit davon betätigt wird, um an das zugeordnete Empfangsregister (26, 48) einen verlängerten Impuls (82) zu liefern, der vor dem Ende der eine logische eins darstellenden Impulse (80) endet, die von der Sendeeinheit empfangen sind, wobei das Empfangsregister (26, 48) der Verarbeitungseinheit (12, 14) als eine Empfangseinheit arbeitet, die auf das Ende des verlängerten Impulses von dem zugeordneten mono-stabilen Empfangsimpulsgenerator (20, 46) anspricht, um einen binären, eine logische eins darstellenden Signalimpuls zu erkennen und zu speichern.

**Revendications**

1. Système de communication de données pour échanger une information par signaux numériques entre en appareil programmable de mesure d'énergie (18) et un ensemble à distance de programmation/lecture (54, 64), le système comprenant un ensemble de traitement principal (12) et un ensemble de traitement asservi (14) destinés à être couplés par communication aux extrémités opposées d'une voie do données (16), chacun des ensembles de traitement pouvant être actionné sélectivement pour fonctionner soit en ensemble d'émission soit en ensemble de réception, caractérisé en ce que l'ensemble de traitement principal (12) comporte un ensemble de commande principal (34) répondant à des signaux de commande (EMC) produits par l'appareil de mesure d'énergie (18) pour émettre des signaux impulsionnels d'horloge (35, 28), et en réponse à un message de réception provenant de l'ensemble asservi de traitement (14) pour détermine la fonction des ensembles de traitement (12, 14), chacun des ensembles (12, 14) comprenant un registre d'émission (24, 50) pour stocker la donnée à transmettre et un registre de réception (26, 48) pour recevoir la donnée transmise, l'ensemble principal (12) comprenant en outre des moyens de porte (30, 32) répondant aux signaux impulsionnels d'horloge (28) et à la sortie du registre d'émission principal (24) de sorte que, avec l'ensemble principal (12) fonctionnant en ensemble émetteur, une lecture de l'appareil de mesure stockée sous forme de bits dans le registre d'émission (24) est transférée de façon sérielle par la voie de données (16) au registre de réception (48) de l'ensemble asservi, et que, avec l'ensemble principal (12) fonctionnant en ensemble de réception, les signaux impulsionnels d'horloge (28) sont transférés par la voie de données à l'ensemble asservi (14), l'ensemble asservi (14) comportant en outre un moyen (44, 46) répondant aux signaux impulsionnels d'horloge (28) en provenance de l'ensemble principal (12) et à la sortie du registre émetteur asservi (50) de sorte que, avec l'ensemble asservi fonctionnant en ensemble émetteur, les bits de données représentant un signal de message stocké dans le registre émetteur asservi (50) sont transférés de façon sérielle par la voie de données (16) au registre de réception (26) de l'ensemble principal (12), le transfert sérial des données étant tel que les bits de données sont transmis sous forme d'impulsions longues et d'impulsions courtes, chaque bit de données étant transmis à une impulsion des signaux impulsionnels d'horloge (28) émis par l'ensemble de commande principal (34) de façon que chaque impulsion d'horloge constitue au moins une partie de chaque bit de données transféré dans l'une ou l'autre direction par la voie de données (16).

2. Système selon la revendication 1, caractérisé en outre en ce que chacun des registres de réception (26, 48) a une capacité prédéterminée pour le stockage de bits de données binaires correspondant à la longueur désirée pour un message, et un moyen (en 34, 52) pour déterminer le moment où chaque registre de recéption (26, 48) est plein pour indiquer la réception d'un message complet, et un moyen (en 34, 52) pouvant fonctionner on réponse audit moyen pour déterminer que le registre de réception est plein pour renvoyer un message à l'ensemble d'émission accusant réception du fait qu'il y a eu réception du message complet.

3. Système selon la revendication 2, caractérisé en outre en ce que chacun des registres de réception (26, 48) comprend un registre à décalage pouvant fonctionner pour recevoir le bit de poids fort du message en premier, suivi par des bits de poids plus faible, le moyen (en 34, 52) pour déterminer si le registre de réception est plein comprenant un moyen pour vérifier un binaire 1 dans la position du bit de poids fort du registre de réception de façon à indiquer avec succès que le registre de réception est plein lorsque le premier bit de chaque message est un 1 binaire obligatoire.

4. Système selon la revendication 2, caractérisé en outre en ce que le moyen (en 34, 52) pour envoyer le message d'accusé de réception peut fonctionner pour envoyer le signal en réponse à une impulsion d'horloge finale en provenance de la source d'horlage (28).

5. Système selon la revendication 4, caractérisé en outre en ce que chacun des ensembles de traitement (12, 14) comprend un moyen (en 34, 52) pour faire un contrôle de parité sur le message reçu par le registre associé de réception (26, 48), et en ce que les moyen de contrôle de parité peut fonctionner en conjonction avec le moyen générateur de signal d'accusé de réception pour transmettre le signal d'accusé de réception dans l'un de deux états binaires, respectivement, représentant seit un contrôle de parité valable soit un contrôle de parité non valable.

6. Système selon la revendication 5, caractérisé en outre en ce que chacun des ensembles de traitement (12, 14) comprend un moyen (en 34, 52) pouvant fonctionner lorsque le dit ensemble marche dans le mode d'émission pour vérifier la réception du signal d'accusé de réception en provenance de l'ensemble de réception et pour stocker l'information sur le contrôle de parité valable ou non valable.

7. Système selon la revendication 1, 2, 3, 4, 5 ou 6, caractérisé en outre en ce que chacun des ensembles de traitement (12, 14) comprend un moyen (en 34, 52) connecté au registre associé d'émission (24, 50) pour contrôler de façon répetitive une situation de 0 binaires stockés dans le registre associé d'émission comme indication que la totalité de la donnée à été sortie du registre associé d'émission et transmise à l'ensemble de réception de sorte que le moyen de contrôle peut fonctionner pour indiquer avec précision le moment où le registre associé d'émission est vide lorsqu'un 1 binaire obligatoire est fourni dans la position du chiffre de poids faible de chaque message à émettre.

8. Système selon la revendication 1, caractérisé en outre en ce que chacun des ensembles de traitement (12, 14) comprend un générateur d'impulsion d'émission unique (22, 44) pouvant fonctionner en conjonction avec le registre associé d'émission (24, 50) en réponse aux signaux impulsionnels d'horloge pour transmission par la voie de données (16) d'une impulsion prolongée (80) signifiant la transmission d'un signal binaire logique à l'état 1 pour chaque bit binaire logique 1 stocké dans le registre associé d'émission.

9. Système selon la revendication 8, caractérisé en outre en ce que chacun des ensembles de traitement (12, 14) comprend un générateur d'impulsion de réception unique (20, 46) qui est connecté au registre associé de réception (26, 48) et qui est branché de manière à recevoir et fonctionner en réponse aux signaux impulsionnels d'horloge pour émettre pour le registre associé de réception (26, 48) une impulsion prolongée (82) qui se termine avant l'achèvement des impulsions logiques 1 (80) provenant de l'ensemble d'emission, le registre de réception (26, 48) de l'ensemble de traitement (12, 14) fonctionnant en ensemble de réception qui peut fonctionner en réponse à l'achèvement de l'impulsion

prolongée provenant du générateur associé d'impulsion de réception unique (20, 46) pour reconnaître et stocker une impulsion de signal à un bit logique 1.

FIG.1

FIG. 2

FIG.3

3/3